# EUROPÄISCHE PATENTSCHRIFT

(11) **EP 0 581 110 B1**
(45) Veröffentlichungstag und Bekanntmachung des Hinweises auf die Patenterteilung: **25.09.1996**
(21) Anmeldenummer: 93111236.1
(22) Anmeldetag: 13.07.1993
(51) Int. Cl.: H03K 17/08, H03K 17/16

(54) **Schaltungsanordnung zum Abbauen von Überspannungen an Transistoren**
Circuit arrangement for reducing overvoltages on transistors
Montage servant à réduire les surtensions aux bornes de transistors

(30) Priorität: 31.07.1992 DE 4225409
(43) Veröffentlichungstag der Anmeldung: 02.02.1994
(73) Patentinhaber: Siemens Nixdorf Informationssysteme Aktiengesellschaft, 33102 Paderborn (DE)
(72) Erfinder: Busch, Peter, Dipl.-Ing. (FH), D-86179 Augsburg (DE); Sterzik, Willi, Dipl.-Ing. (FH), D-86165 Augsburg (DE)
(74) Vertreter: Fuchs, Franz-Josef, Dr.-Ing.

(56) Entgegenhaltungen:
- EP-A- 0 382 906
- DE-A- 3 629 501
- FR-A- 2 427 712
- SIEMENS FORSCHUNGS- UND ENTWICKLUNGSBERICHTE, Bd.14, Nr.2, 1985, BERLIN DE Seiten 56 - 61 TIHANYI 'Protection of Power MOSFETs from Transient Overvoltages'
- MOTOROLA TECHNICAL DEVELOPMENTS., Bd.2, Januar 1982, SCHAUMBURG, ILLINOIS US Seiten 8 - 9 SOMMERER 'Grounded Emitter Zener Biasing'

## Beschreibung

Die Erfindung betrifft eine Schaltungsanordnung zum Abbauen von Überspannungen an Transistoren gemäß dem Oberbegriff der Ansprüche 1, 2 und 3.

Transistoren können im Betrieb durch kurzzeitige Spannungsspitzen, die die maximale Bauteilsperrpsannung überschreiten, zerstört werden. MOS-Feldeffekttransistoren sind "Avalanche"-geschützt, das heißt, das Bauteil verhält sich im gesperrten Zustand gegenüber Überspannungen wie eine Zenerdiode. Dieser Schutz ist aber nur zulässig bis ca. 1 % der Dauerverlustleistung des Transistors. Periodische Spannungsspitzen, die energiereicher sind, führen zur Zerstörung des Bauteils.

Die vollständige Verlustleistung des Bauteils kann genutzt werden, wenn durch entsprechende Ansteuerungen der Steuerelektrode des Transistors der Transistor neben seiner Grundfunktion auch als Überspannungsableiter benutzt wird. Hierzu wird eine schnelle Zenerdiode, z.B. eine Transient-Suppressor-Diode, und eine gegensinnig zur Zenerdiode gepolte weitere Diode zwischen der Abfluß- und der Steuerelektrode des Transistors geschaltet. Die Zenerdiode beginnt ab ihrer Einsatzspannung zu leiten. Die Spannung an der Steuerelektrode des Transistors wird in ihrem Wert angehoben und der Transistor beginnt zu leiten. Dadurch werden Überspannungen auf einen Wert unterhalb der Durchbruchspannung des Transistors begrenzt.

Die Schaltungsmaßnahme, zwischen der Abflußelektrode und der Steuerelektrode eines Transistors zwei Dioden gegensinnig in Serie zu schalten, von denen wenigstens eine eine Zenerdiode ist, ist beispielsweise aus DE-A-4 122 347, Figur 4 und EP-A-0 321 663 bekannt.

Die Grundfunktion des Transistors sollte durch die beschriebene Maßnahme nicht gestört werden. Ein Nachteil der beschriebenen Maßnahme ist aber, daß diese Bedingung nicht erfüllt wird. Bei Spannungssprüngen der Transistor-Ansteuerspannung führt die Zenerdiode wegen ihrer parasitären Kapazität bereits unterhalb ihrer Einsatzspannung einen kapazitiven Verschiebestrom. Dieser führt zu einem Spannungsabfall über einen der Steuerelektrode des Transistors zugeordneten Ansteuerwiderstand und kann damit eine fehlerhafte Ansteuerung des Transistors verursachen.

Aus dem Dokument: Tihanyi, J.: Protection of Power MOSFET's from Transient Overvoltage, in: Siemens Forsch.-u. Entwickl.-Ber., Bd. 14 (1985) Nr. 2, Springer-Verlag 1985, S. 56 - 61 ist eine weitere derartige Schaltungsanordnung bekannt, die desweiteren eine bemerkenswerte Teilschaltung, gezeigt in einer Figur 11, aufweist. Die Teilschaltung besteht aus einem mit C bezeichneten Kondensator, einer mit D2 bezeichneten Diode und einem auf ein Massepotential bezogenen und mit R bezeichneten Widerstand. Der Kondensator C ist mit der oben erwähnten Serienschaltung, gebildet aus den beiden gegensinnig gepolten Dioden, von denen mindestens eine eine Zenerdiode ist, mit seiner einen Anschlußseite verbunden. Mit seiner anderen Anschlußseite ist er mit der restlichen Teilschaltung verbunden. Dabei ist die Diode D2 mit einer der Steuerelektrode des betreffenden Transistors zugeordneten Anschlußseite mit der besagten Steuerelektrode und mit einer der Steuerelektrode zugeordenten gegenüberliegenden Seite mit dem Kondensator C und mit dem Widerstand R verbunden.

Die aus den Elementen Kondensator C, Diode D2 und Widerstand R gebildete Teilschaltung ist als Ganzes zu sehen und hat die Aufgabe, die Zenerdiode der Serienschaltung, die eine Hochvolt-Zenerdiode mit allen damit zusammenhängenden Nachteilen ist, zu entlasten, so daß für die Zenerdiode eine Diode mit kleinerem Spannungswert verwendet werden kann.

Die Diode D2 und der Widerstand R haben dabei die Aufgabe, die durch Einführen des Kondensators C, der als teilweiser Ersatz für die Zenerdiode der Serienschaltung arbeitet, verursachten zusätzlichen Verschiebeströme (S. 60, rechte Spalte, vorletzter Absatz) zu reduzieren, indem sie die Nachladeströme des Kondensators C ableiten. Das eigentliche Problem, nämlich die in ihrer Auswirkung viel erheblicheren Verschiebeströme von der Abflußelektrode des Transistors über die Dioden der Serienschaltung und dem Kondensator C auf die Steuerelektrode des Transistors aufgrund der parasitären Kapazitäten der Dioden der Serienschaltung bleibt davon unberührt.

Zur Dimensionierung des Widerstandes R der Teilschaltung sei noch erwähnt, daß gemäß Figur 11 des genannten Dokuments der Widerstand R der Teilschaltung einem auf eine Bezugsspannung bezogenen Widerstand entspricht, der gemäß dem Dokument einen Wert von 10 kOhm (Figur 9) aufweist. Aus der praktischen Erfahrung heraus ist desweiteren bekannt, bei einer entsprechend dem Dokument vorliegenden Taktfrequenz einen für die Ansteuerung des Transistors verwendeten Transistor-Ansteuerwiderstand mit 5 bis 47 Ohm zu wählen. Damit ist der Widerstand R der Teilschaltung größer gewählt als der Transistor-Ansteuerwiderstand.

Aufgabe der Erfindung ist es, eine Schaltungsanordnung der eingangs genannten Art anzugeben, bei der die Gefahr einer fehlerhaften Ansteuerung aufgrund parasitärer Kapazitäten von für eine Schutzschaltung verwendeten Dioden nicht mehr gegeben ist.

Diese Aufgabe wird durch die im kennzeichnenden Teil des Anspruchs 1, 2 oder 3 angegebenen Merkmale gelöst.

Gemäß der Lösung nach Anspruch 1 ist neben einem Ansteuerwiderstand, über den die Ansteuerung des Transistors wirkt, ein zweiter Widerstand vorgesehen, über den die Zenerdiode wirkt. Eine Entkopplungsdiode entkoppelt die Widerstände. Dadurch kann der zweite Widerstand niederohmig gewählt werden, so daß er die für die Grundfunktion des Transistors maßgebende Ansteuerung nicht beeinflußt.

Gemäß der Lösung nach Anspruch 2 werden Spannungssprünge von der Zenerdiode fern gehalten.

Gemäß der Lösung nach Anspruch 3 werden die Maßnahmen nach Anspruch 1 und 2 miteinander kombiniert und damit die Vorteile der jeweiligen Lösung zusammen genutzt.

Nachfolgend wird ein Ausführungsbeispiel der Erfindung anhand einer Zeichnung näher erläutert. Darin zeigen
Figur 1 eine erste Ausführungsform der Schaltungsanordnung gemäß der Erfindung, und
Figur 2 eine zweite Ausführungsform der Schaltungsanordnung gemäß der Erfindung.

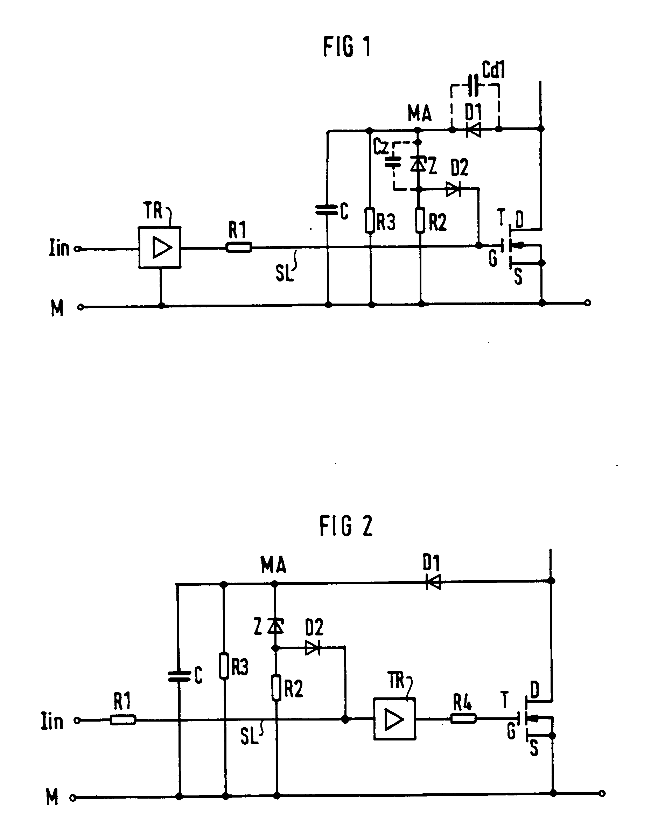

In der Figur 1 ist ein Transistor T mit einer Steuerelektrode G, einer Abflußelektrode D und einer Bezugselektrode S zu sehen. Der Transistor T wird über eine Steuerleitung SL, an der ein Steuersignal Iin anliegt und die auf die Steuerelektrode G des Transistors T geführt ist, angesteuert. In der Steuerleitung SL ist ein erster Widerstand R1 angeordnet, der als Transistor-Ansteuerwiderstand wirkt. In der Steuerleitung SL ist ferner eine Ansteuerschaltung TR vor dem ersten Widerstand R1 angeordnet, die das Steuersignal Iin in eine entsprechende Transistor-Steuerspannung umformt und den Strom verstärkt. Die Bezugselektrode S des Transistors T und ein Bezugspotentialeingang der Ansteuerschaltung TR sind mit einem Bezugspunkt M, der ein Massepotential führt, verbunden.

Bei dem Transistor T handelt es sich um einen N-Kanal-MOS-Feldeffekttransistor. Dieser bewirkt, daß die nachfolgend beschriebenen Dioden der Schaltungsanordnung in der in den Figuren 1 und 2 dargestellten Weise gepolt sind. Bei der Verwendung eines P-Kanal-MOS-Feldeffekttransistors sind die Dioden entsprechend umgekehrt gepolt angeordnet.

Die Schaltungsanordnung nach Figur 1 weist eine Serienschaltung aus einer ersten Diode D1 und einer Zenerdiode Z auf. Ihnen sind parasitäre Kapazitäten Cdl und Cz zugeordnet, die in der Figur 1 gestrichelt gezeichnet sind. Die erste Diode Dl und die Zenerdiode Z sind in der Serienschaltung in der Weise angeordnet, daß die Kathoden der angesprochenen Dioden zueinander gerichtet sind und die Anode der ersten Diode D1 mit der Abflußelektrode D des Transistors T verbunden ist.

Im Stand der Technik ist die Anode der Zenerdiode Z mit der Steuerleitung SL direkt verbunden. Gemäß der Figur 1 ist zwischen der Steuerleitung SL und der aus der ersten Diode D1 und der Zenerdiode Z gebildeten Serienschaltung eine Entkopplungsdiode D2 angeordnet. Die Entkopplungsdiode D2 ist gegensinnig zur Zenerdiode Z gepolt, so daß die Anode der Zenerdiode Z und die Anode der Entkopplungsdiode D2 zueinander weisen. Desweiteren ist am Verbindungspunkt der Entkopplungsdiode D2 mit der aus der ersten Diode D1 und der Zenerdiode Z gebildeten Serienschaltung ein zweiter Widerstand R2 angeschlossen, desssen gegenüberliegende Anschlußseite auf den Bezugspunkt M geschaltet ist.

Der Wert des zweiten Widerstandes R2 kann in der Größenordnung von 10 % des Wertes des ersten Widerstandes R1 gewählt werden. Die kapazitiv entkoppelte Störspannung wird damit auf 10 % eines vormaligen Wertes reduziert. Negative Störspannungen werden durch die Entkopplungsdiode D2 abgeblockt und beeinflussen die Ansteuerung des Transistors T nicht.

Anstelle der Entkopplungsdiode D2 und des zweiten Widerstandes R2 kann an einem Mittelabgriff MA zwischen der ersten Diode D1 und der Zenerdiode Z der aus der ersten Diode D1 und der Zenerdiode Z gebildeten Serienschaltung eine Parallelschaltung aus einem Kondensator C und einem dritten Widerstand R3 angeschlossen sein, die auf den mit der Bezugselektrode S verbundenen Bezugspunkt M geschaltet ist. Durch diese Maßnahme wird der Spitzenwert der über den Transistor T anstehenden Spannung in dem Kondensator C als Gleichspannung gespeichert. Die Zeitkonstante unterhalb der Ansprechschwelle des Transistors T kann mit t = R3 x C mit einem sehr hochohmigen Widerstand R3 sehr groß gewählt werden. Die parasitäre Kapazität Cdl der ersten Diode D1 bildet einen Spannungsteiler mit dem Kondensator C. Die Kapazität des Kondensators C sollte deshalb wesentlich größer sein als die parasitäre Kapazität Cdl der ersten Diode D1.

Die dem Transistor T überlagerten Spannungssprünge werden im Verhältnis der parasitären Kapazität Cdl zur Kapazität des Kondensators C abgeschwächt auf den Kondensator C übertragen. Wenn die Einsatzspannung der Zenerdiode Z erreicht wird, fließt ein Strom über den ersten Widerstand R1. Die Spannung an der Steuerelektrode G des Transistors T steigt und der Transistor T wird leitend geschaltet. Die Uberspannung am Transistor T wird begrenzt. Da der erste Widerstand R1 relativ niederohmig sein kann, ist die Zeitkonstante des Kondensators C im Uberspannungsfall ungefähr t = R1 x C und sollte eine in einem zugehörigen Datenblatt angegebene Ausschaltzeit ta des Transistors T nicht überschreiten. Dadurch wird die Ansteuerspannung des Transistors T nach einem Überspannungsfall nicht gespeichert sondern folgt der tatsächlich anliegenden Überspannung. Die Störungen der Ansteuerspannung des Transistors T werden auf einen Prozentsatz von ungefähr dem Verhältnis der parasitären Kapazität Cd1 zu der Kapazität des Kondensators C abgesenkt.

Wie in der Figur 1 dargestellt, können die beiden vorbeschriebenen Schaltungsmaßnahmen auch gleichzeitig verwendet werden.

In der Figur 2 ist eine Ausführungsform der Schaltungsanordnung gezeigt, bei der die Ansteuerschaltung TR nach den vorbeschriebenen Schaltungsmaßnahmen geschaltet ist. Zwischen der Ansteuerschaltung TR und der Steuerelektrode G des Transistors T ist in diesem Fall noch ein Vorwiderstand R4 angeordnet. Die Ansteuerschaltung TR ist hier als Linearverstärker aufzufassen, auch wenn er im Prinzip ein digitales Signal verstärkt.

## Patentansprüche

1. Schaltungsanordnung zum Abbauen von Uberspannungen an einem Transistor mit einer Abfluß-(D), Steuer-(G) und auf einen Bezugspunkt geschalteter Bezugselektrode (S) unter Verwendung einer Serienschaltung aus einer ersten Diode (D1) und einer dazu gegensinnig gepolten Zenerdiode (Z), die zwischen der Abflußelektrode (D) und einer mit der Steuerelektrode verbundenen Steuerleitung (SL) angeordnet ist, sowie unter Verwendung eines in der Steuerleitung angeordneten ersten Widerstandes (R1) als Transistor-Ansteuerwiderstand,
**dadurch gekennzeichnet,**
daß zwischen der Steuerleitung (SL) und der aus der ersten Diode (D1) und der Zenerdiode (Z) gebildeten Serienschaltung eine gegensinnig zur Zenerdiode (Z) gepolte Entkopplungsdiode (D2) angeordnet ist, deren der Steuerelektrode des Transistors (T) zugeordneten gegenüberliegende Seite mit der aus der ersten Diode (D1) und der Zenerdiode (Z) gebildeten Serienschaltung verbunden und über einen zweiten Widerstand (R2), der einen im Vergleich zu dem ersten Widerstand (R1) einen sehr viel kleineren Wert aufweist, auf den mit der Bezugselektrode (S) verbundenen Bezugspunkt (M) geschaltet ist.

2. Schaltungsanordnung zum Abbauen von Uberspannungen an einem Transistor mit einer Abfluß-(D), Steuer-(G) und auf einen Bezugspunkt geschalteter Bezugselektrode (S) unter Verwendung einer Serienschaltung aus einer ersten Diode (D1) und einer dazu gegensinnig gepolten Zenerdiode (Z), die zwischen der Abflußelektrode (D) und einer mit der Steuerelektrode verbundenen Steuerleitung (SL) angeordnet ist, sowie unter Verwendung eines in der Steuerleitung angeordneten ersten Widerstandes (R1) als Transistor-Ansteuerwiderstand,
**dadurch gekennzeichnet,**
daß an einem Mittelabgriff (MA) zwischen der ersten Diode (D1) und der Zenerdiode (Z) der aus der ersten Diode (D1) und der Zenerdiode (Z) gebildeten Serienschaltung eine Parallelschaltung aus einem Kondensator (C) und einem dritten Widerstand (R3) angeschlossen ist, die auf den mit der Bezugselektrode (S) verbundenen Bezugspunkt (M) geschaltet ist.

3. Schaltungsanordnung zum Abbauen von Uberspannungen an einem Transistor mit einer Abfluß-(D), Steuer-(G) und auf einen Bezugspunkt geschalteter Bezugselektrode (S) unter Verwendung einer Serienschaltung aus einer ersten Diode (D1) und einer dazu gegensinnig gepolten Zenerdiode (Z), die zwischen der Abflußelektrode (D) einer mit der Steuerelektrode verbundenen Steuerleitung (SL) angeordnet ist, sowie unter Verwendung eines in der Steuerleitung angeordneten ersten Widerstandes (R1) als Transistor-Ansteuerwiderstand,
**dadurch gekennzeichnet,**
daß zwischen der Steuerleitung (SL) und der aus der ersten Diode (D1) und der Zenerdiode (Z) gebildeten Serienschaltung eine gegensinnig zur Zenerdiode (Z) gepolte Entkopplungsdiode (D2) angeordnet ist, deren der Steuerelektrode des Transistors (T) zugeordneten gegenüberliegende Seite mit der aus der ersten Diode (D1) und der Zenerdiode (Z) gebildeten Serienschaltung verbunden und über einen zweiten Widerstand (R2), der einen im Vergleich zu dem ersten Widerstand (R1) einen sehr viel kleineren Wert aufweist, auf den mit der Bezugselektrode (S) verbundenen Bezugspunkt (M) geschaltet ist, und daß an einem Mittelabgriff (MA) zwischen der ersten Diode (D1) und der Zenerdiode (Z) der aus der ersten Diode (D1) und der Zenerdiode (Z) gebildeten Serienschaltung eine Parallelschaltung aus einem Kondensator (C) und einem dritten Widerstand (R3) angeschlossen ist, die ebenfalls auf den mit der Bezugselektrode (S) verbundenen Bezugspunkt (M) geschaltet ist.

## Claims

1. Circuit arrangement for reducing overvoltages across a transistor having a drain electrode (D), a control electrode (G) and a reference electrode (S) connected to a reference point, using a series circuit formed by a first diode (D1) and a zener diode (Z) reverse-biased with respect thereto, which is arranged between the drain electrode (D) and a control line (SL) connected to the control electrode, and using a first resistor (R1), which is arranged in the control line, as a transistor drive resistor, characterized in that a decoupling diode (D2) is arranged between the control line (SL) and the series circuit formed by the first diode (D1) and the zener diode (Z), the said decoupling diode (D2) is reverse-biased with respect to the zener diode (Z) and its side opposite to the side assigned to the control electrode of the transistor (T) is connected to the series circuit formed by the first diode (D1) and the zener diode (Z) and is connected via a second resistor (R2), which has a very much smaller value compared with the first resistor (R1), to the reference point (M) connected to the reference electrode (S).

2. Circuit arrangement for reducing overvoltages across a transistor having a drain electrode (D), a control electrode (G) and a reference electrode (S) connected to a reference point, using a series circuit formed by a first diode (D1) and a zener diode (Z) reverse-biased with respect thereto, which is arranged between the drain electrode (D) and a control line (SL) connected to the control electrode, and using a first resistor (R1), which is arranged in the control line, as a transistor drive resistor, characterized in that a parallel circuit formed by a capacitor (C) and a third resistor (R3) is connected to a centre tap (MA) between the first diode (D1) and the zener diode (Z) of the series circuit formed by the first diode (D1) and the zener diode (Z) and is connected to the reference point (M) connected to the reference electrode (S).

3. Circuit arrangement for reducing overvoltages across a transistor having a drain electrode (D), a control electrode (G) and a reference electrode (S) connected to a reference point, using a series circuit formed by a first diode (D1) and a zener diode (Z) reverse-biased with respect thereto, which is arranged between the drain electrode (D) and a control line (SL) connected to the control electrode, and using a first resistor (R1), which is arranged in the control line, as a transistor drive resistor, characterized in that a decoupling diode (D2) is arranged between the control line (SL) and the series circuit formed by the first diode (D1) and the zener diode (Z), the said decoupling diode (D2) is reverse-biased with respect to the zener diode (Z) and its side opposite to the side assigned to the control electrode of the transistor (T) is connected to the series circuit formed by the first diode (D1) and the zener diode (Z) and is connected via a second resistor (R2), which has a very much smaller value compared with the first resistor (R1), to the reference point (M) connected to the reference electrode (S), and in that a parallel circuit formed by a capacitor (C) and a third resistor (R3) is connected to a centre tap (MA) between the first diode (D1) and the zener diode (Z) of the series circuit formed by the first diode (D1) and the zener diode (Z) and is likewise connected to the reference point (M) connected to the reference electrode (S).

## Revendications

1. Montage de suppression de surtensions d'un transistor comportant une électrode (D) de drain, une électrode (G) de commande et une électrode (S) de référence branchée à un point de référence, utilisant un circuit série constitué d'une première diode (D1) et d'une diode Zener (Z) polarisée dans le sens opposé à la première diode et disposée entre l'électrode (D) de drain et un conducteur (SL) de commande relié à l'électrode de commande, et utilisant une première résistance (R1) intercalée dans le conducteur de commande comme résistance de commande du transistor,
caractérisé en ce que
il est disposé entre le conducteur (SL) de commande et le circuit série formés de la première diode (D1) et de la diode Zener (Z) une diode (D2) de découplage, qui est polarisée dans le sens opposé à la diode Zener (Z), dont le côté associé éloigné de l'électrode de commande du transistor (T) est relié au circuit série de la première diode (D1) et de la diode Zener (Z) et est branché, par l'intermédiaire d'une seconde résistance (R2) de valeur beaucoup plus petite que la première résistance (R1), au point (M) de référence relié à l'électrode (S) de référence.

2. Montage de suppression de surtensions d'un transistor comportant une électrode (D) de drain, une électrode (G) de commande et une électrode (S) de référence branchée à un point de référence, utilisant un circuit série constitué d'une première diode (D1) et d'une diode (Z) Zener polarisée en sens opposé à la première diode et disposée entre l'électrode (D) de drain et un conducteur (SL) de commande relié à l'électrode de commande, et utilisant une première résistance (R1) intercalée dans le conducteur de commande comme résistance de commande de transistor,
caractérisé en ce que
il est connecté à une prise médiane (MA) se trouvant entre la première diode (D1) et la diode Zener (Z) du circuit série formé de la première diode (D1) et de la diode Zener (Z), un circuit parallèle constitué d'un condensateur (C) et d'une troisième résistance (R3), lequel circuit parallèle est branché au point (M) de référence relié à l'électrode (S) de référence.

3. Montage de suppression de surtensions d'un transistor comportant une électrode (D) de drain, une électrode (G) de commande et une électrode (S) de référence branchée à un point de référence, utilisant un circuit série constitué d'une première diode (D1) et d'une diode Zener (Z) polarisée en sens opposé à la première diode et disposée entre l'électrode (D) de drain et un conducteur (SL) de commande relié à l'électrode de commande, et utilisant une première résistance (R1) intercalée dans le conducteur de commande comme résistance de commande de transistor,
caractérisé en ce que
il est disposé entre le conducteur (SL) de commande et le circuit série formé de la première diode (D1) et de la diode Zener (Z) une diode (D2) de découplage, qui est polarisée en sens opposé à la diode Zener (Z), dont le côté associé éloigné de l'électrode de commande du transistor (T) est relié au circuit série formé de la première diode (D1) et de la diode Zener (Z) et est branché, par l'intermédiaire d'une seconde résistance (R2) de valeur beaucoup plus petite que la première résistance (R1), au point (M) de référence relié à l'électrode (S) de référence, et il est connecté à une prise (MA) médiane se trouvant entre la première diode (D1) et la diode Zener (Z) du circuit série formé de la diode (D1) et de la diode Zener (Z) un circuit parallèle constitué d'un condensateur (C) et d'une troisième résistance (R3), qui est branché également au point (M) de référence relié à l'électrode (S) de référence.
